# FASCICULE DE BREVET EUROPEEN

(11) **EP 3 416 465 B1**
(45) Date de publication et mention de la délivrance du brevet: **28.06.2023**
(21) Numéro de dépôt: 18173809.7
(22) Date de dépôt: 23.05.2018
(51) Int. Cl.: H05K 5/00, H05K 7/14, F21S 43/19

(54) **ENSEMBLE COMPORTANT UN BOITIER AVANT, UN BOITIER ARRIÈRE, ET UNE CARTE ÉLECTRONIQUE DESTINÉE A ÊTRE FIXÉE ENTRE LE BOITIER AVANT ET UN BOITIER ARRiÈRE**
ANORDNUNG, DIE EIN VORDERES GEHÄUSE, EIN HINTERES GEHÄUSE UND EINE ELEKTRONISCHE KARTE ZUR ANBRINGUNG ZWISCHEN DEM VORDEREN UND DEM HINTEREN GEHÄUSE UMFASST
ASSEMBLY COMPRISING A FRONT HOUSING, A REAR HOUSING, AND AN ELECTRONIC CARD INTENDED FOR BEING ATTACHED BETWEEN THE FRONT HOUSING AND A REAR HOUSING

(30) Priorité: 16.06.2017 FR 1755452
(43) Date de publication de la demande: 19.12.2018
(73) Titulaire: PSA Automobiles SA, 78300 Poissy (FR)
(72) Inventeur: VIDEIRA, FILIPE, 78140 VELIZY VILLACOUBLAY (FR)

(56) Documents cités:
- WO-A1-2009/043642
- FR-A1- 2 941 129
- JP-A- 2006 287 128
- JP-A- 2012 160 430

## Description

L'invention concerne l'assemblage des cartes électroniques dans des boitiers et concerne plus particulièrement un ensemble comportant un boitier avant, un boitier arrière et une carte électronique destinée à être fixée entre le boitier avant et le boitier arrière.

Un tel ensemble peut être un dispositif d'éclairage et/ou de signalisation tel qu'un feu arrière de véhicule automobile.

On entend ici par "dispositif d'éclairage et/ou de signalisation" un dispositif ou équipement comportant un réflecteur, agencé de manière à renvoyer vers une direction déterminée des rayons lumineux qui sont issus d'une source de lumière de type ampoule ou d'une pluralité de sources de lumières telles que des diodes électroluminescentes (ou LEDs).

En général, dans un dispositif d'éclairage et/ou signalisation, lorsqu'une carte électronique est intégrée dans un feu arrière, celle-ci est soit vissée sur un support, soit juste assemblé par clipage sur le support.

Quand elle assemblée par clipage, il faut laisser un jeu de quelques dixièmes de millimètres afin que l'opération de clipage puisse se faire (sans jeu les moyens de clipage ne peuvent pas se verrouiller).

Ce jeu entre la carte et le support engendre les inconvénients suivants :
- vibrations générant des bruits parasites ;
- vibrations pouvant générer de la poussière (par frottement donc usure entre les pièces) : cette poussière pouvant se déposer dans des zones visibles ;
- vibrations pouvant générer un scintillement indésirable de la fonction allumée d'éclairage et/ou de signalisation.

De plus en plus de dispositifs d'éclairage et/ou de signalisation comportent des sources de lumière à LEDs qui sont implantées directement sur la carte et qui doivent générer un faisceau qui soit précisément focalisé dans le bloc optique du dispositif d'éclairage et/ou de signalisation et les assemblages de carte par clipage sont de plus en plus utilisés de par leur facilité de montage/démontage.

On connait notamment du document FR2548292A un dispositif de fixation conçu pour assurer le montage d'une plaquette ou d'une plaque support de composants dans des appareils ou instruments électriques et elle a trait plus particulièrement à un dispositif de fixation capable de serrer les extrémités de la plaquette et également capable de la monter de manière amovible sur une plaque de montage ou châssis.

Ce document divulgue un rattrapage de jeu suivant l'épaisseur de la plaque (carte) mais pas dans la direction d'insertion de la carte dans le châssis. Le pré-maintien et assemblage par clipage n'est par ailleurs pas évoqué.

On connait également du document JP 2006287128A un ensemble conforme au préambule de la revendication 1.

L'invention a donc pour but de proposer une solution permettant d'améliorer la fixation d'une carte électronique par clipage avec les contraintes spécifiques liées aux dispositifs d'éclairage et/ou de signalisation de véhicules automobiles notamment en termes de fabrication des pièces obtenues par moulage, d'étanchéité et de coût.

Selon un premier aspect, elle concerne un ensemble conforme à la partie caractérisante de la revendication 1.

Selon une caractéristique, l'organe à déformation programmée est formé à partir d'un bord arrière de la carte faisant face au fond du boitier arrière.

Selon une autre caractéristique, les moyens de clipage comportent des moyens portés par la carte et des moyens antagonistes portés par le boitier avant qui coopèrent entre eux avec un jeu déterminé pour le pré-maintien de la carte sur le boitier avant.

Selon une autre caractéristique, la carte est pré-maintenue en outre par des moyens de guidage appartenant au boitier avant et coopérant avec le bord avant de la carte, opposé au bord arrière.

Selon une autre caractéristique, le boitier arrière comporte un fond et le fond du boitier comporte des excroissances venues de matière avec le boitier arrière, aptes à coopérer avec l'organe à déformation programmée.

Selon une autre aspect, l'invention concerne un ensemble conforme à l'objet de la revendication 6.

D'autres caractéristiques et avantages de l'invention apparaîtront à l'examen de la description détaillée ci-après, et des dessins annexés sur lesquels :
- la figure 1 illustre schématiquement selon une vue en coupe, une partie d'un bloc optique mettant en évidence l'importance d'une fixation sans jeu de la carte électronique supportant une source lumineuse telle qu'une LED;
- les figure 2A, 2B et 2C illustrent respectivement selon une vue en coupe (2A) et des vues de détail (2B et 2C), l'assemblage d'un feu arrière d'un véhicule automobile équipé d'un dispositif d'éclairage et/ou de signalisation selon l'invention ;
- la figure 3 illustre une vue en éclatée d'un dispositif d'éclairage et/ou de signalisation selon l'invention ; et
- la figure 4 illustre une vue en perspective d'une partie d'un feu arrière avant son assemblage dans le boitier du dispositif d'éclairage et/ou de signalisation selon l'invention.

Dans ce qui suit, on considère, à titre d'exemple non limitatif, un dispositif de signalisation de type « lanterne » et faisant partie d'un feu arrière de véhicule, éventuellement de type automobile. Mais, l'invention n'est pas limitée à cette application. Le dispositif d'éclairage peut être de type DRL ("Daytime running Light (or Lamp)") destiné à être automatiquement mis en fonctionnement (ou allumé) lorsque le véhicule qu'il équipe se met à avancer, de type « feu de recul » ou encore de type « feu stop ».

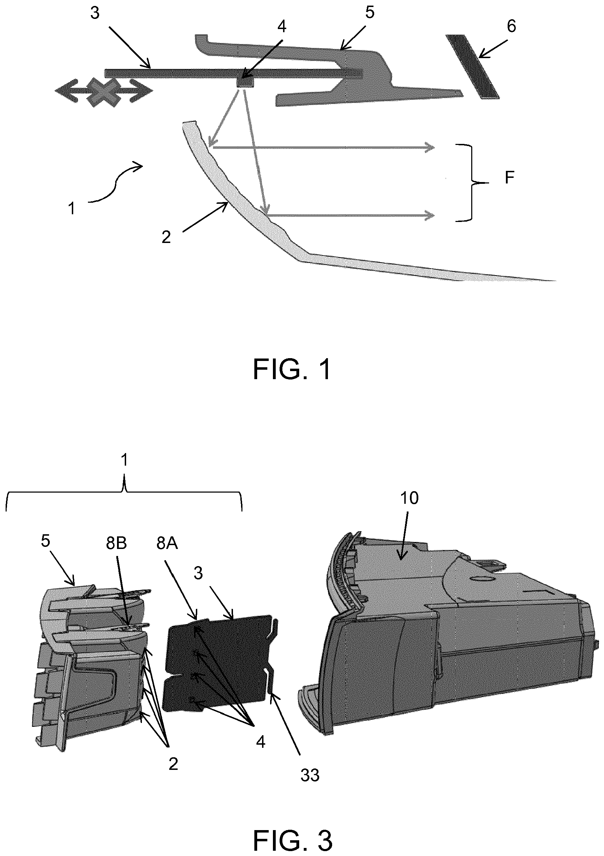

La figure 1 illustre schématiquement selon une vue en coupe, un bloc optique d'un dispositif d'éclairage et/ou de signalisation mettant en évidence l'importance d'un assemblage sans jeu de la carte électronique supportant une source lumineuse telle qu'une LED.

Le boc optique 1 représenté de manière schématique, comporte un réflecteur de forme parabolique 2, accueillant une carte électronique 3 supportant une LED 4, maintenue dans un premier boitier 5, dit boitier avant, recouvert partiellement par un masque 6 de feu arrière.

La carte 3 est assemblée dans le boitier avant 5 de manière à ce que la LED 4 soit parfaitement positionnée en regard du réflecteur 2 pour générer un faisceau lumineux F dans la direction souhaitée avec les caractéristiques photométriques souhaitées.

Une double flèche barrée symbolise, sur la figure, un positionnement sans jeu dans la direction d'insertion de la carte dans le boitier avant 5

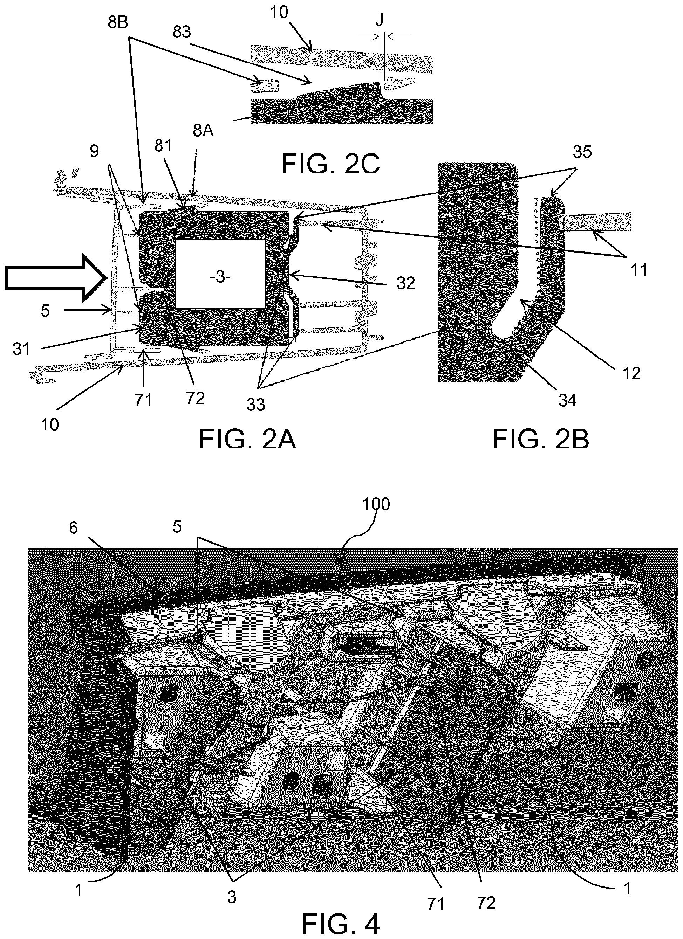

Tel qu'illustré en référence aux figures 2A, 2B et 2C, la carte 3 est d'abord pré-maintenue dans le boitier avant 5 par des moyens 8A et 8B de clipage de la carte 3 sur le boitier avant 5 et par des moyens de guidage 71 et 72 (glissière 71 et nervure 72)

Les moyens de clipage 8A et 8B comportent sur chacun des bords latéraux de la carte 3, s'étendant dans la direction d'insertion de la carte 3, symbolisé par une flèche, de la gauche vers la droite sur le figure 2A, une rampe 81 qui coopère avec une patte flexible 8B appartenant au boitier avant 5. La patte flexible 8B comporte une ouverture 83 dont un des bords sert de contre butée, ou moyen antagoniste, à la butée formée par l'extrémité de la rampe 81.

Un jeu J de l'ordre de quelques dixièmes de millimètre est laissé entre le bord de l'ouverture 83, situé à proximité de l'extrémité libre de la patte flexible 8B, et l'extrémité de la rampe 81 située en regard dudit bord. Un teljeu J est toujours nécessaire dans un assemblage de ce type.

La carte 3 est ainsi pré-maintenue entre les moyens de clipage 8A, 8B, les moyens de guidage 71 et 72 et des excroissances de matière 9 issues du boitier avant 5 (ou venues de matière avec le boitier 5) et formant des appuis en contact avec le bord avant 31 de la carte 3. Par bord avant 31, on entend un des bords perpendiculaires aux bords latéraux de la carte 3 qui est orienté vers le boitier avant 5.

Le bord arrière 32 de la carte 3, donc opposé au bord avant 31, comporte deux pattes flexibles 33 obtenues directement par usinage du bord arrière 32 de la carte 3.

Chacune des pattes 33 présente la forme générale d'un boomerang comportant des première et seconde branches 34 et 35 se prolongeant l'une de l'autre et dont la première 34 est rattachée à la carte 3 et la seconde 35 est libre. La première branche 34 part approximativement du milieu du bord arrière 32, avec un angle d'environ 45° par rapport au bord arrière 32 et la seconde 35 s'étend ensuite parallèlement au bord arrière 32 vers le bord latéral de la carte 3.

Chacune des pattes 33 est obtenue après usinage du bord arrière 32 de la carte 3. Cet usinage crée une découpe ou échancrure 12 partant approximativement du milieu du bord arrière 32 et s'étendant d'abord selon un angle d'environ 45° par rapport au bord arrière 32 puis selon une direction parallèle au bord arrière 32 et débouchant vers le bord latéral de la carte 3.

La largeur de l'échancrure 12 correspond sensiblement à la largeur de la patte 33. Elle est de l'ordre de quelques millimètres.

Les extrémités des secondes branches 35 présentent une élasticité déterminée suffisante pour, en se déformant (la déformation est représentée en pointillés : les extrémités des secondes branches 35 se rapprochant du bord arrière 32 de la carte 3 sous contrainte mécanique extérieure), absorber au minimum le jeu J quand elles sont sous contrainte.

Les pattes flexibles 33 se comportent comme des organes de déformation programmée. Elles viennent de matière avec la carte 3.

La contrainte mécanique est exercée sur les secondes branches 35 lors de l'assemblage du boitier avant 5 avec un boitier 10, dit boitier arrière, suivant la direction d'insertion (de la gauche vers la droite sur la figure 2B).

Le boitier arrière 10 présente des excroissances 11 issues du fond du boitier arrière 10 (venues de matière avec le fond du boitier arrière 10) et définissant des appuis en contact avec les extrémités des secondes branches 35.

Une fois l'assemblage réalisé, le boitier avant 5 est fixé sur le boitier arrière 10 par exemple par vissage. Plus aucun mouvement de la carte 3 à l'intérieur de l'ensemble formé par le boitier avant 5 et le boitier arrière 10, n'est possible garantissant un positionnement précis et fiable dans le temps de la LED 5 vis-à-vis du réflecteur 2.

La figure 3 illustre une vue en éclatée représentant le bloc optique 1 comportant le boitier avant 5 et la carte 3, et le boitier arrière 10. Dans le mode de réalisation illustré sur cette figure, quatre LEDs 4 sont implantées sur la carte 3 et viennent respectivement en regard de quatre réflecteurs 2.

La figure 4 illustre une vue en perspective d'un feu arrière 100, sans le boitier arrière 10, avant son assemblage dans le boitier arrière 10.

Sur cette figure, le feu arrière 100 comporte deux blocs optiques 1 similaires comportant deux boitiers avant 5 similaires, réunis en une seule pièce, deux cartes 3 pré-maintenues sur leurs boitiers avant 5 respectifs et un masque 6 fixé sur la face avant des boitiers 5.

En synthèse, la présente invention offre une solution optimisée en termes de fabrication, sans ajout de pièce et donc à moindre coût, compatible des procédés de moulage de pièces plastiques, par exemple en polypropylène (PP) pour obtenir notamment les boitiers avant 5 et arrière 10 avec des excroissances de matière utiles pour réaliser les butées 9, 11 et les moyens de guidage 71 et 72.

La carte électronique 3 est généralement réalisée à partir d'un composite de résine époxy renforcé de fibre de verre, désigné par FR4 (abréviation de l'anglais Flame Résistant 4), matériau couramment utilisé pour la fabrication de cartes de circuit imprimé.

Ce matériau FR4 est capable d'accepter des usinages de pattes 33 avec des déformations limitées à quelques dixièmes de millimètre.

La forme décrite pour l'organe de déformation programmée peut être différente d'un boomerang. Toute forme adaptée pour remplir la condition de déformation programmée pour absorber le jeu de clipage, et venue de matière avec la carte, rentre dans le cadre de la présente invention.

## Revendications

1. Ensemble comportant un boitier avant (5), un boitier arrière (10), et une carte électronique (3) destinée à être fixée entre le boitier avant (5) et un boitier arrière (10), dans lequel la carte (3) est pré-maintenue par des moyens de clipage (8A, 8B) sur le boitier avant (5) avec un jeu déterminé (J) et dans lequel la carte (3) comporte au moins un organe à déformation programmée (33) venant de matière avec la carte (3) permettant de maintenir la carte (3) à l'intérieur dudit ensemble quand le boitier avant (5) est fixé sur le boitier arrière (10) en absorbant le jeu déterminé (J), **caractérisé en ce que** l'organe à déformation programmée (33) définit une patte flexible comportant des première et seconde branches (34 et 35) en prolongement l'une de l'autre ; la première branche (34) étant rattachée au bord arrière (32) de la carte (3) et la seconde branche (35) étant libre, et **en ce que** les première et deuxième branches (34 et 35) sont obtenues par usinage d'une échancrure (12) dans le bord arrière (32) de la carte (3) ; ladite échancrure (12) s'étendant à partir de la base de la première branche (34) vers l'extrémité de la seconde branche (35) qui est apte à se déformer pour absorber le jeu déterminé (J).

2. Ensemble selon la revendication 1, **caractérisé en ce que** l'organe à déformation programmée (33) est formé à partir d'un bord arrière (32) de la carte (3) faisant face au fond du boitier arrière (10).

3. Ensemble selon l'une des revendications précédentes, **caractérisé en ce que** les moyens de clipage comportent des moyens (8A) portés par la carte (3) et des moyens antagonistes (8B) portés par le boitier avant (5) qui coopèrent entre eux avec un jeu (J) déterminé pour le pré-maintien de la carte (3) sur le boitier avant (5).

4. Ensemble selon l'une des revendications précédentes, **caractérisé en ce que** la carte (3) est pré-maintenue en outre par des moyens de guidage (71 et 72) appartenant au boitier avant (5) et coopérant avec le bord avant de la carte, opposé au bord arrière (32)

5. Ensemble selon l'une des revendications précédentes, **caractérisé en ce que** le boitier arrière (10) comporte un fond et **en ce que** le fond du boitier (10) comporte des excroissances (11) venues de matière avec le boitier arrière (10) aptes à coopérer avec l'organe à déformation programmée (33)

6. Ensemble selon l'une des revendications précédentes, **caractérisé en ce qu'**il constitue un feu arrière (100) de véhicule automobile ; le boitier avant (5) supportant un bloc optique (1) et un masque (6) et la carte électronique (3) supportant au moins une source lumineuse (4) coopérant avec au moins un réflecteur (2) du bloc optique (1) pour générer au moins un faisceau lumineux (F).

## Patentansprüche

1. Einheit mit einem vorderen Gehäuse (5), einem hinteren Gehäuse (10) und einer elektronischen Karte (3), die dazu bestimmt ist, zwischen dem vorderen Gehäuse (5) und einem hinteren Gehäuse (10) befestigt zu werden, wobei die Karte (3) durch Clip-Mittel (8A, 8B) auf dem vorderen Gehäuse (5) mit einem bestimmten Spiel (J) befestigt ist und wobei die Karte (3) mindestens ein Organ mit programmierter Verformung (33) umfasst, das mit der Karte (3) einstückig ist und es ermöglicht, die Karte (3) im Inneren der Einheit zu halten, wenn das vordere Gehäuse (5) auf dem hinteren Gehäuse (10) befestigt ist, indem es das bestimmte Spiel (J) absorbiert, **dadurch gekennzeichnet, dass** das Organ mit programmierter Verformung (33) eine flexible Lasche definiert, die einen ersten und einen zweiten Schenkel (34 und 35) in Verlängerung des einen zum anderen aufweist; wobei der erste Schenkel (34) an der Hinterkante (32) der Karte (3) befestigt ist und der zweite Schenkel (35) frei ist, und dass der erste und der zweite Schenkel (34 und 35) durch Bearbeitung einer Aussparung (12) in der Hinterkante (32) der Karte (3) erhalten werden; wobei sich die Aussparung (12) von der Basis des ersten Schenkels (34) bis zum Ende des zweiten Schenkels (35) erstreckt, der sich verformen kann, um das bestimmte Spiel (J) zu absorbieren.

2. Baugruppe nach Anspruch 1, **dadurch gekennzeichnet, dass** das Organ mit programmierter Verformung (33) ausgehend von einer hinteren Kante (32) der Karte (3) gebildet wird, die dem Boden des hinteren Gehäuses (10) zugewandt ist.

3. Anordnung nach einem der vorhergehenden Ansprüche, **dadurch gekennzeichnet, dass** die Klippmittel von der Karte (3) getragene Mittel (8A) und vom vorderen Gehäuse (5) getragene Gegenmittel (8B) umfassen, die miteinander mit einem Spiel (J) zusammenwirken, das für das Vorhalten der Karte (3) auf dem vorderen Gehäuse (5) bestimmt ist.

4. Anordnung nach einem der vorhergehenden Ansprüche, **dadurch gekennzeichnet, dass** die Karte (3) zusätzlich durch Führungsmittel (71 und 72) vorgehalten wird, die zum vorderen Gehäuse (5) gehören und mit dem vorderen Rand der Karte zusammenwirken, der dem hinteren Rand (32) gegenüberliegt.

5. Anordnung nach einem der vorhergehenden Ansprüche, **dadurch gekennzeichnet, dass** das hintere Gehäuse (10) einen Boden aufweist und dass der Boden des Gehäuses (10) Auswüchse (11) aufweist, die aus dem Material des hinteren Gehäuses (10) geformt sind und mit dem Organ mit programmierter Verformung (33) zusammenwirken können.

6. Baugruppe nach einem der vorhergehenden Ansprüche, **dadurch gekennzeichnet, dass** sie eine Rückleuchte (100) eines Kraftfahrzeugs bildet; wobei das vordere Gehäuse (5) einen optischen Block (1) und eine Maske (6) trägt und die elektronische Karte (3) mindestens eine Lichtquelle (4) trägt, die mit mindestens einem Reflektor (2) des optischen Blocks (1) zusammenwirkt, um mindestens ein Lichtbündel (F) zu erzeugen.

## Claims

1. Assembly comprising a front case (5), a rear case (10), and an electronic card (3) intended to be fixed between the front case (5) and a rear case (10), in which the card (3) is pre-held by clipping means (8A, 8B) on the front case (5) with a determined clearance (J) and in which the card (3) comprises at least one programmed deformation member (33) integral with the card (3) allowing the card (3) to be held inside the said assembly when the front case (5) is fixed on the rear case (10) by absorbing the determined clearance (J) **characterized in that** the programmed deformation member (33) defines a flexible tab comprising first and second branches (34 and 35) in extension of each other; the first branch (34) being attached to the rear edge (32) of the card (3) and the second branch (35) being free, and **in that** the first and second branches (34 and 35) are obtained by machining a notch (12) in the rear edge (32) of the card (3); the said notch (12) extending from the base of the first branch (34) to the end of the second branch (35) which is capable of deforming to absorb the determined play (J).

2. The assembly of claim 1, **characterized in that** the programmed deformation member (33) is formed from a rear edge (32) of the board (3) facing the bottom of the rear housing (10).

3. Assembly according to one of the preceding claims, **characterized in that** the clipping means comprise means (8A) carried by the card (3) and opposing means (8B) carried by the front casing (5) which cooperate with each other with a given clearance (J) for pre-maintaining the card (3) on the front casing (5).

4. Assembly according to one of the preceding claims, **characterized in that** the card (3) is additionally pre-held by guide means (71 and 72) belonging to the front case (5) and cooperating with the front edge of the card, opposite the rear edge (32).

5. Assembly according to one of the preceding claims, **characterized in that** the rear casing (10) comprises a bottom and **in that** the bottom of the casing (10) comprises protrusions (11) integral with the rear casing (10) and able to cooperate with the programmed deformation member (33).

6. Assembly according to one of the preceding claims, **characterized in that** it constitutes a rear light (100) of a motor vehicle; the front casing (5) supporting an optical unit (1) and a mask (6) and the electronic card (3) supporting at least one light source (4) cooperating with at least one reflector (2) of the optical unit (1) in order to generate at least one light beam (F).
